# EUROPEAN PATENT APPLICATION

(11) **EP 1 793 435 A2**
(43) Date of publication of application: **06.06.2007**
(21) Application number: 06256142.8
(22) Date of filing: 30.11.2006
(51) Int. Cl.: H01L 51/50, H01L 51/54

(54) **Organic light emitting device**

(30) Priority: 30.11.2005 KR 20050115992; 20.11.2006 KR 20060114586
(71) Applicant: Samsung SDI Co., Ltd., Suwon-si Gyeonggi-do (KR)
(72) Inventor: Jeong, Hye In c/o Samsung SDI Co. Ltd., Yongin-si, Gyeonggi-do (KR); Song, Ok Keun c/o Samsung SDI Co. Ltd., Yongin-si, Gyeonggi-do (KR); Koo, Young Mo c/o Samsung SDI Co. Ltd., Yongin-si, Gyeonggi-do (KR); Choi, Sung Jin c/o Samsung SDI Co. Ltd., Yongin-si, Gyeonggi-do (KR); Kim, Tae Shick c/o Samsung SDI Co. Ltd., Yongin-si, Gyeonggi-do (KR)
(74) Representative: Mounteney, Simon James

(57) **Abstract**

The instant disclosure relates to an organic light emitting device with an improved blue light emitting efficiency. One embodiment of the organic light emitting device has an advantageous effect of increasing the blue light emitting efficiency remarkably without changing other elements' properties by forming organic layers including compounds having specific wavelengths at both sides of the emissive layer or by fabricating the organic layers with the compounds having specific wavelengths.

## Description

### CROSS-REFERENCE TO RELATED APPLICATION

### BACKGROUND

### 1. Field

The present disclosure relates to an organic light emitting device and, more particularly, to an organic light emitting device including compounds having specific photoluminescence spectrum maximum wavelengths in a hole transporting layer and an electron transporting layer.

### 2. Description of the Related Technology

In general, an organic light emitting device includes a pair of electrodes, such as an anode electrode and a cathode electrode, and at least one organic layer interposed between the electrodes. Holes and electrons are injected from the anode and cathode electrodes to the organic layer as a voltage is applied between the electrodes. Then, excitons with an excited energy state are produced in the organic layer, and light emits while the excitons return to the ground energy state.

The organic layer of the organic light emitting device may have a single layer structure or a multilayer structure. The single layer structure only includes a light emitting layer between the two electrodes. The multilayer structure includes a light emitting layer and at least one of a hole injection layer, a hole transporting layer, an electron blocking layer, a hole blocking layer, an electron injection layer, an electron transporting layer, etc. Here, the electron blocking layer refers to a layer that regulates electron mobility in order to balance with hole mobility.

The multilayer structure increases quantum efficiency and decreases drive voltage by including the layers described above therein, and improves the luminous efficiency by regulating the recombination of electrons and holes. Various research efforts have been focused on materials to enhance the performance of the organic light emitting device.

### SUMMARY

One aspect of the instant disclosure provides an organic light emitting device that improves luminous efficiency of organic light emitting diodes, particularly, blue light emitting efficiency, and does not deteriorate other properties.

According to a first aspect of the invention there is provided an organic light emitting device according to Claim 1. Preferred features of this aspect are set out in Claims 2 to 15.

According to a second aspect of the invention, there is provided an organic light emitting display device as set out in Claim 16.

According to a third aspect of the invention there is provided an electronic device as set out in Claim 17.

According to a fourth aspect of the invention there is provided a method of making an organic light emitting device as set out in Claim 18. Preferred features of this aspect are set out in Claims 19 and 20.

An organic light emitting device in accordance with the embodiments of the invention has an advantageous effect of increasing the blue light emitting efficiency remarkably without changing other elements' properties by forming organic layers including specific compounds at both sides of the emissive layer.

### BRIEF DESCRIPTION OF THE DRAWINGS

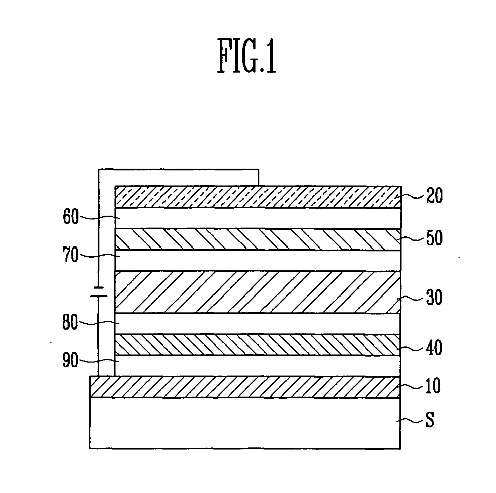

Fig. 1 is a schematic cross-sectional view illustrating a structure of an organic light emitting device in accordance with one embodiment.

### DETAILED DESCRIPTION

The instant disclosure will now be described more fully hereinafter with reference to the accompanying drawings.

In an organic light emitting device having the multilayer structure described above, the hole transporting layer may serve to transport holes while improving the luminous efficiency by aiding the recombination of the holes in the emissive layer. The hole transporting layer may be configured to increase blue light emitting efficiency in addition to the aforementioned functions. For instance, Korean Publication Nos. 10-2005-0077231 and 10-2003-0058458 disclosed materials for the hole transporting layer. Furthermore, the electron transporting layer may serve to transport electrons while improving the luminous efficiency by aiding the recombination of the electrons in the emissive layer. Various materials can be used for the electron transporting layer.

Fig. 1 is a cross-sectional view illustrating a structure of an organic light emitting device in accordance with one embodiment. The organic light emitting device includes a first organic layer 40, an emissive layer 30 and a second organic layer 50 between a first electrode 10 and a second electrode 20.

In this embodiment, the first electrode 10 may serve as an anode electrode while the second electrode 20 may serve as a cathode electrode. The first electrode may be formed of, for example, ITO. The second electrode may be formed of, for example, lithium, magnesium, aluminum, aluminum-lithium, calcium, magnesium-indium, magnesium-silver, and the like.

The emissive layer 30 is a layer in which holes and electrons from the first electrode 10 and the second electrode 20 recombine with each other, and then, return to the ground state to emit light. The emissive layer 30 may be formed of any suitable light-emitting material. Examples of such light-emitting material include, but are not limited to, ADN (Chemical Formula 28), MADN (Chemical Formula 29)

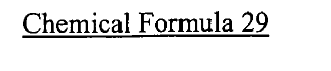

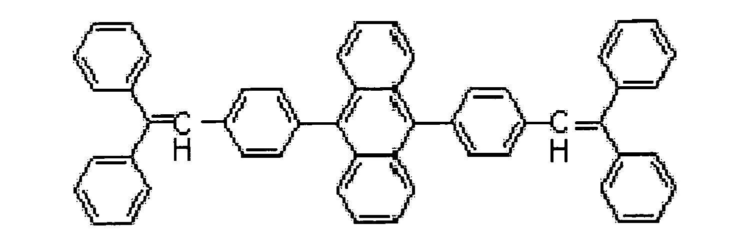

The first organic layer 40 includes a first compound having a photoluminescence (PL) spectrum maximum wavelength of about 400nm to about 500nm. The term "maximum wavelength" may also be referred to as a "peak wavelength." The first compound serves to enhance luminance efficiency of the emissive layer 30 although the first compound itself does not emit light in the organic light emitting device. The second organic layer 50 includes a second compound having a photoluminescence (PL) spectrum maximum wavelength of about 400nm to about 500nm. In this embodiment, the first and second compounds themselves are blue light emitting materials, and are different to each other.

In this embodiment, the first organic layer 40 is a hole transporting layer. The hole transporting layer serves to transport holes from the anode electrode to the emissive layer efficiently. In addition to the first compound described above, the hole transporting layer may further include at least one of TPTE (Chemical Formula 23) and MTBDAB (Chemical Formula 24). It will be appreciated that any other suitable hole transporting material can be used for the first organic layer 40.

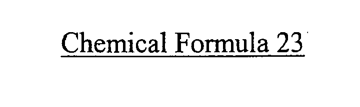

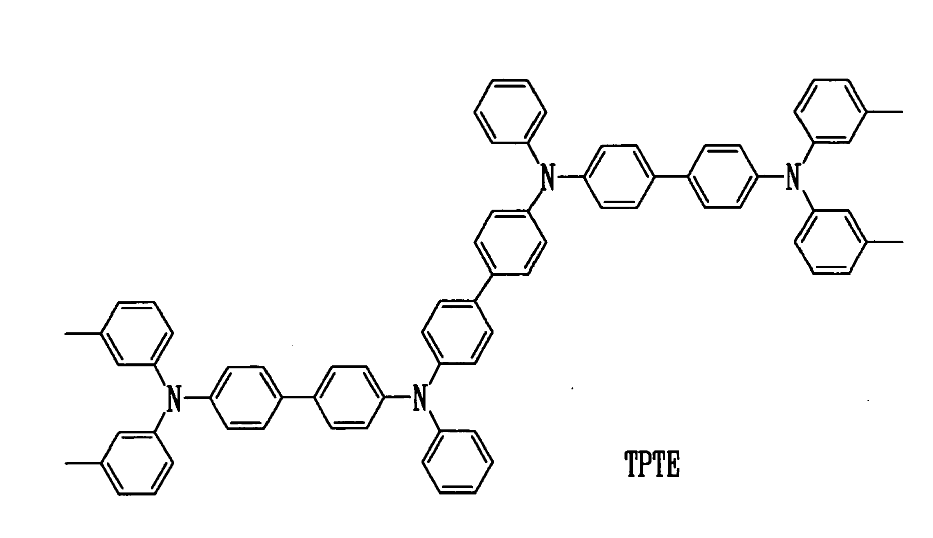

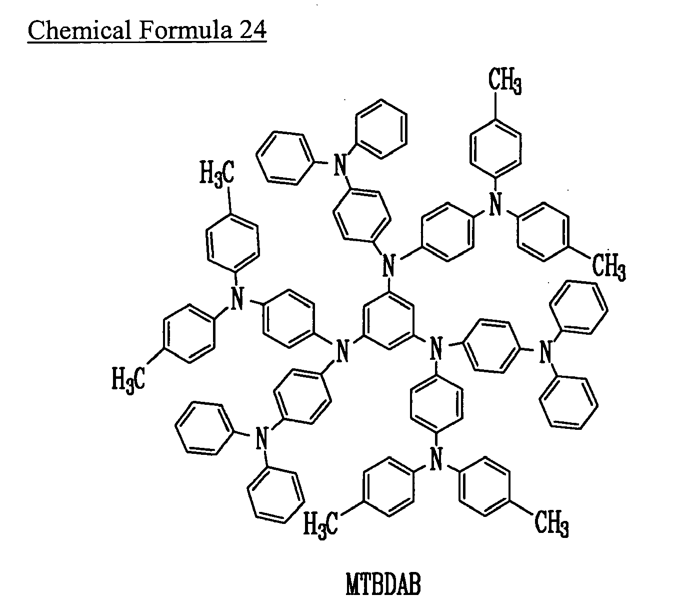

Examples of the first compound for the hole transporting layer may include, but are not limited to, N,N'-bis(3-methylphenyl)-N,N'-diphenyl-[1,1-biphenyl-4,4' diamine (TPD, Chemical Formula 1), N,N'-di(naphthalene-1-yl)-N,N'-diphenylbenzidine (α-NPD, Chemical Formula 2), Spiro-NPD (Chemical Formula 3), and Spiro-TAD (Chemical Formula 4).

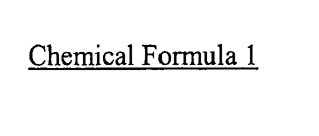

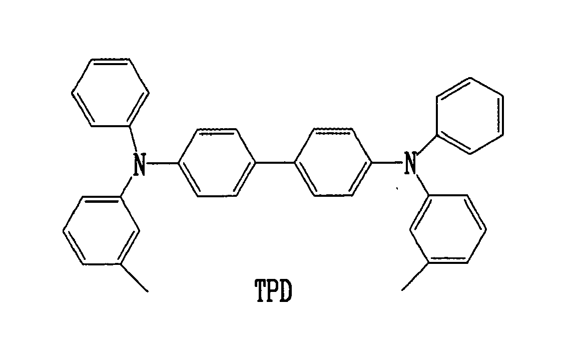

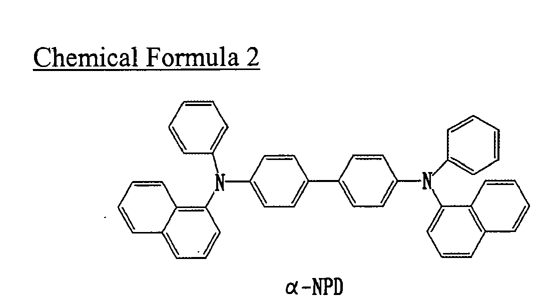

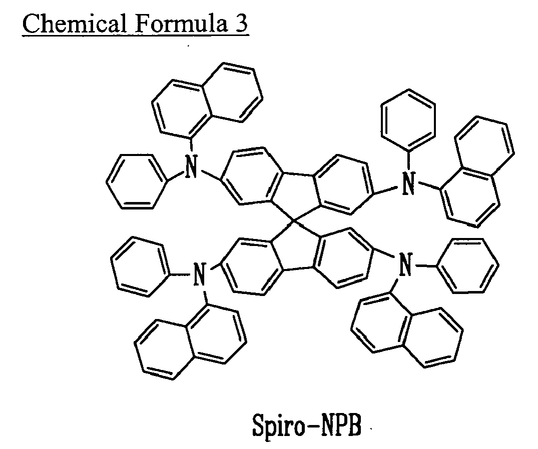

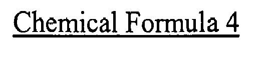

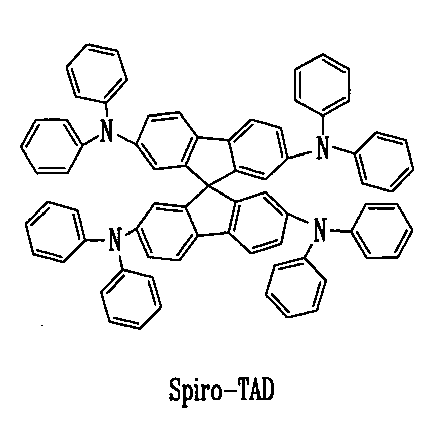

Other examples of the first compound include materials having a hole-injection property, such as copper phthalocyanine (CuPc), TCTA that is a starburst-type amine (Chemical Formula 5), m-MTDATA (Chemical Formula 6), and HI406 (available from Idemitsu Kosan Co., Ltd., Tokyo, Japan).

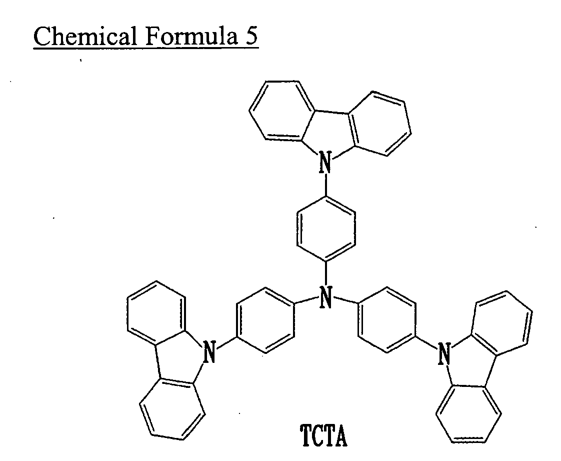

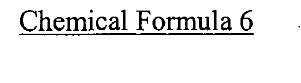

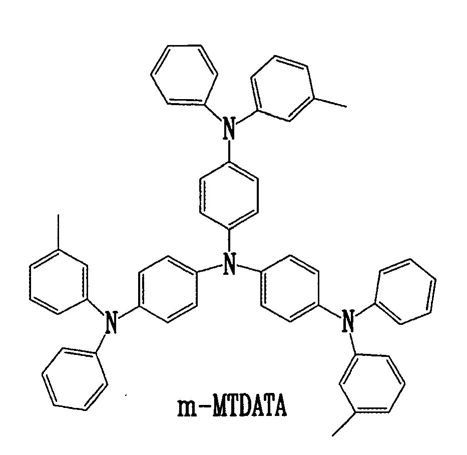

Yet other examples of the first compound may include Flrpic (Chemical Formula 10), CzTT (Chemical Formula 11), PPCP (chemical Formula 12), DST (Chemical Formula 13), TPA (Chemical Formula 14), Spiro-DPVBi (Chemical Formula 15), AZM-Zn (Chemical Formula 16), Anthracene (Chemical Formula 17), TPB (Chemical Formula 18), OXD-4 (Chemical Formula 19), BBOT (Chemical Formula 20), compound A (Chemical Formula 21), compound B (Chemical Formula 22), and a compound represented by Chemical Formula 25.

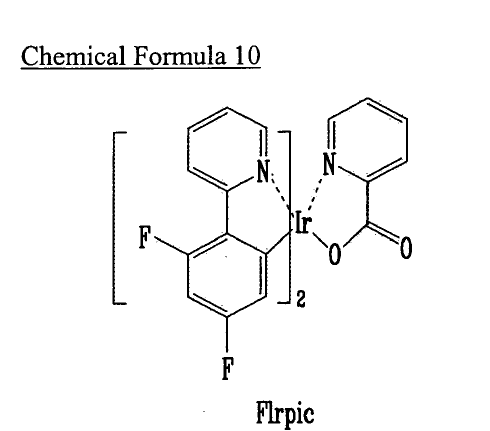

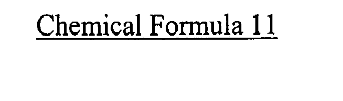

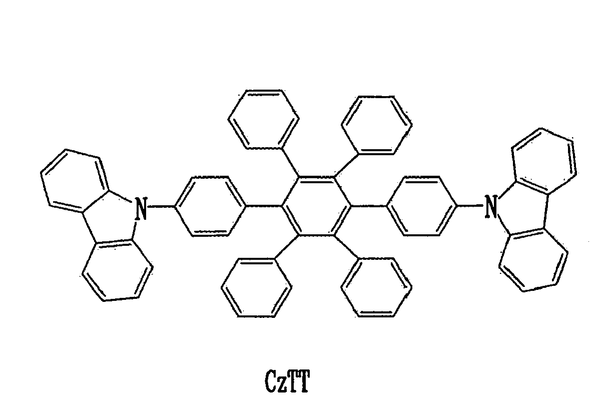

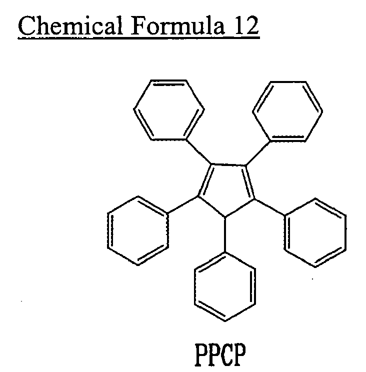

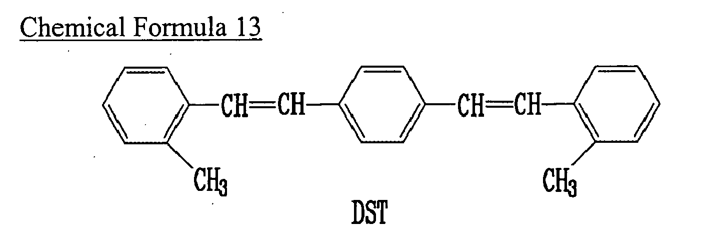

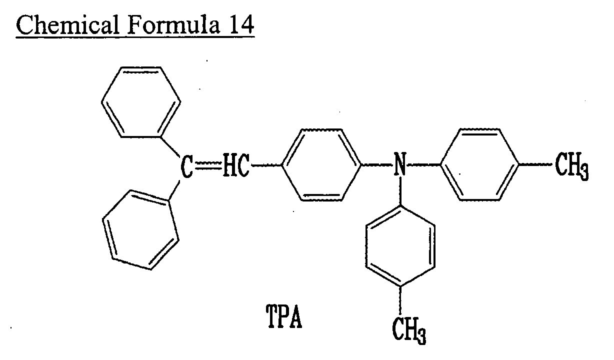

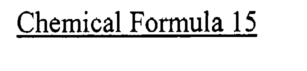

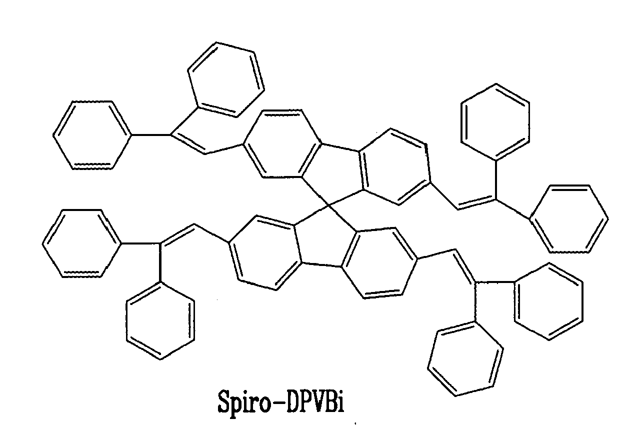

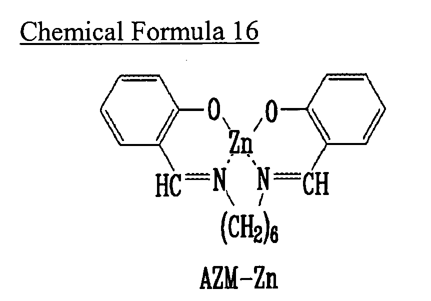

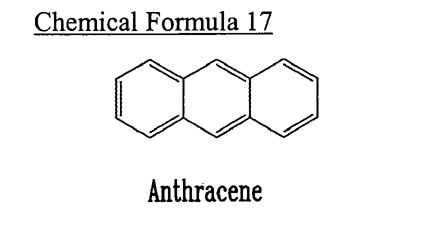

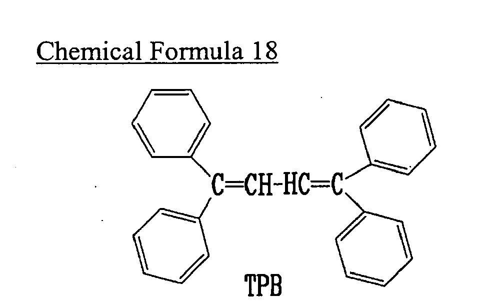

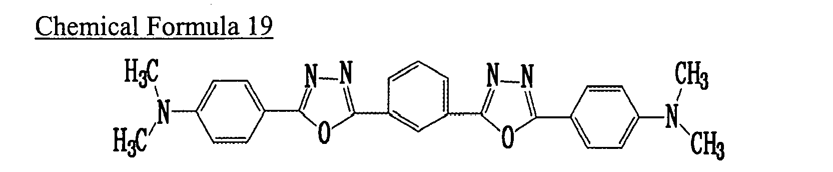

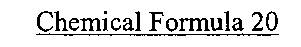

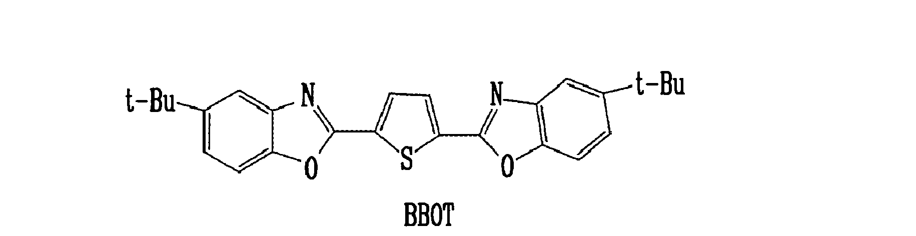

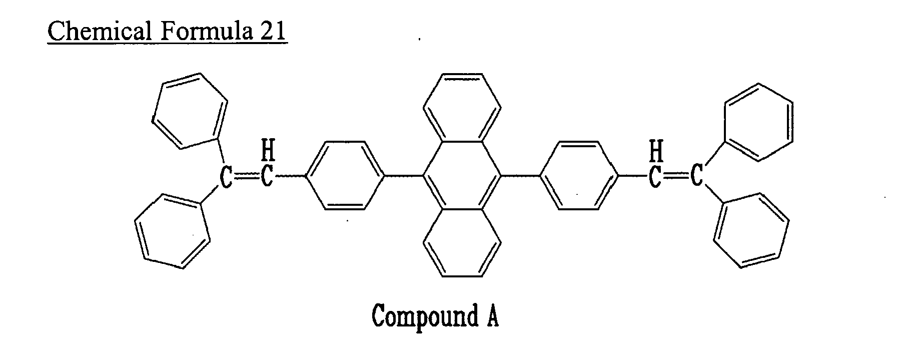

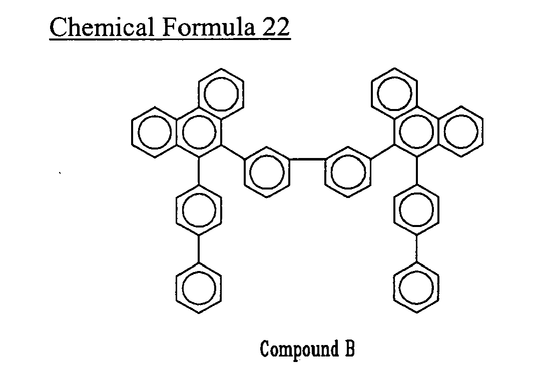

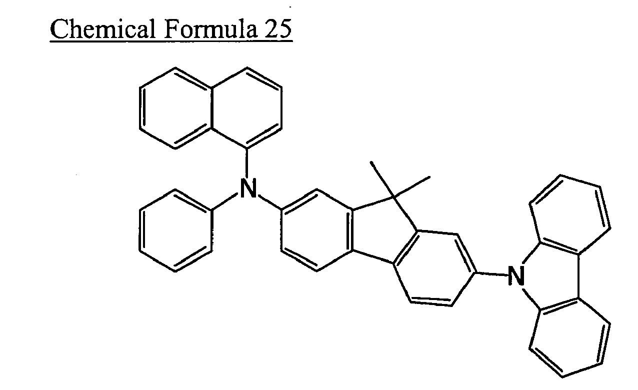

Further, N,N'-di(1-naphthyl)-N-N'-diphenylbenzidine (NPD), bis(4-dimethylamino-2-methylphenyl)-phenylmethane, 1,1-bis(4-di-p-tolylaminophenyl)cyclohexane, 1,1-bis(4-di-p-tolylaminophenyl)-4-phenylcyclohexane, etc., can be used solely or mixed with one or more of the examples of the first compound described above.

In another embodiment, the first organic layer 40 may be formed by doping a metal phthalocyanine organic compound with a p-type semiconductor material. Moreover, in addition to the aforementioned examples of the first compound, various materials disclosed in Japanese Patent Laid-Open Nos. 2000-192028, 2000-191560, 2000-48955, 2000-7604 and 1998-11063, and U.S. Patent No. 6,591,636 can also be used as the first compound.

The first compound may be in an amount of about 30wt%~100wt% with reference to the total weight of the first organic layer 40. Optionally , the first compound may be in an amount of about 50 wt% to about 100 wt% with reference to the total weight of the first organic layer 40.

The thickness of the hole transporting layer may be in a range of about 100 Å to about 1,500Å. The first compound may be included in the hole transporting material by thermal evaporation or spin coating.

In the embodiment shown in Figure 1, the second organic layer 50 is an electron transporting layer. The electron transporting layer serves to transport electrons from the cathode electrode to the emissive layer efficiently. In addition to the second compound described above, the second organic layer 50 may further include any suitable electron transporting materials. Examples of the electron transporting material include, but are not limited to, aluminum complex (Alq3-(tris(8-quinolinolato)-aluminum)), and a compound represented by Chemical Formula 26.

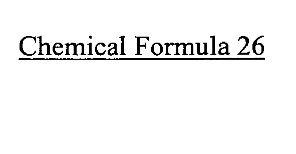

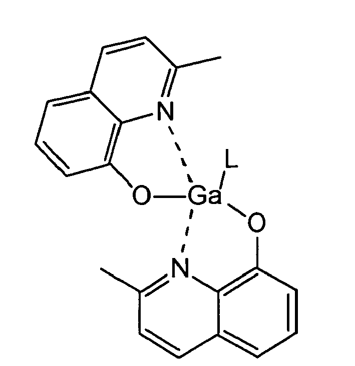

The electron transporting material may include the second compound which has a PL spectrum maximum wavelength of about 400nm to about 500nm. Examples of the second compound include, but are not limited to, Bepp2 (Chemical Formula 7), Bpy-OXD (Chemical Formula 8), Bpy-OXDpy (Chemical Formula 9), the Chemical Formula 27, a compound represented by Chemical Formual 27, oligothiophene, perfluorinated oligo-p-phenylene, 2,5-diarylsilole, etc. and their derivatives.

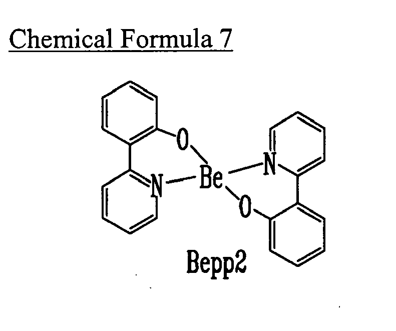

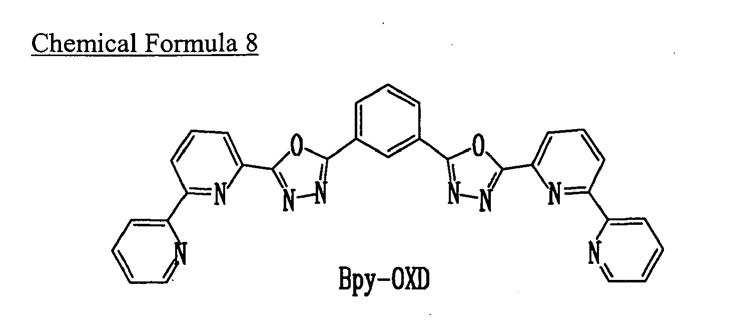

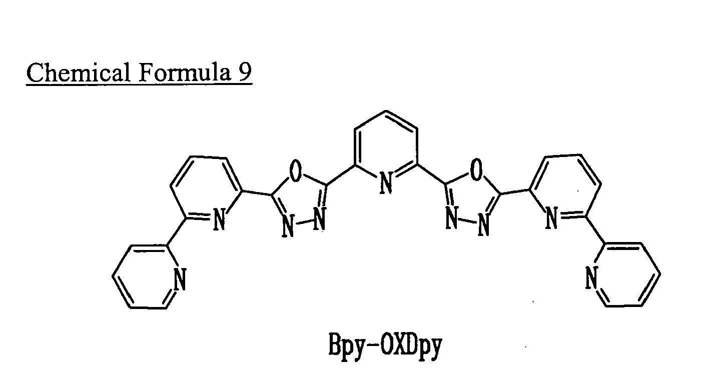

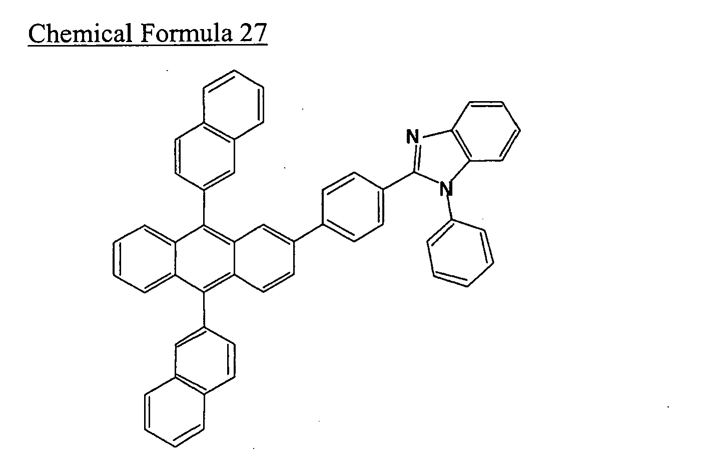

In one embodiment, the second compound may be in an amount of about 30 wt% to about 100 wt% with reference to the total weight of the second organic layer 50. Optionally, the second compound may be in an amount of about 50 wt% to about 100 wt% with reference to the total weight of the second organic layer 50.

The second compound may be vacuum-deposited to the electron transporting material to form an electron transporting layer. Here, the thickness of the electron transporting layer may be in a range of about 150 to about 600Å.

The organic light emitting device in accordance with another embodiment includes a first organic layer 40, an emissive layer 30 and a second organic layer 50 between a first electrode 10 and a second electrode 20. The first organic layer 40 may be formed of a first compound having a PL spectrum maximum wavelength of about 400nm to about 500nm. The second organic layer 50 may be formed of a second compound having a PL spectrum maximum wavelength of about 400nm to about 500nm. In this embodiment, the first and second compounds in the above-mentioned wavelengths are blue light emitting materials and are different to each other.

In this embodiment, the first organic layer is formed solely of the first compound and the second organic layer is formed solely of the second compound. The first and second organic layers may serve as a hole transporting layer and an electron transporting layer, respectively. The first compound for the hole transporting layer may be one or more of the examples of the first compound described above. One or more of the examples of the second compound described above can be used as the second compound.

In the illustrated embodiment, the organic light emitting device may also include an electron injection layer 60, a hole blocking layer 70, an electron blocking layer 80, and a hole injection layer 90. It will be appreciated that at least one of the foregoing layers 60, 70, 80, and 90 can be omitted. It will also be appreciated that the organic light emitting device may further include additional layers depending on its design.

In another embodiment, an organic light emitting display device may include the organic light emitting device described above. In such an embodiment, the display device may include an array of pixels, each pixel including at least one organic light emitting device described above.

In yet another embodiment, an electronic device may include the display device described above. Examples of the electronic device include, but are not limited to, various consumer electronic products including, but are not limited to, a mobile phone, a telephone, a television, a computer monitor, a computer, a hand-held computer, a personal digital assistant (PDA), a microwave, a refrigerator, a stereo system, a cassette recorder or player, a DVD player, a CD player, a VCR, an MP3 player, a radio, a camcorder, a camera, a digital camera, a portable memory chip, a washer, a dryer, a washer/dryer, a copier, a facsimile machine, a scanner, a multi-functional peripheral device, a wrist watch, a clock, and the like.

### Embodiment 1

A hole transporting layer having a thickness of 15nm is formed by using TPTE (Chemical Formula 23) and a compound represented by Chemical Formula 25 as a hole transporting material on the surface of a substrate, on which an ITO film is deposited as an anode electrode. After the formation of the hole transporting layer, an emissive layer having a thickness of 30nm is established by depositing Blue dopant BD118 of Idemitsu Kosan, Co., Ltd. (Tokyo, Japan) to ADN (Chemical Formula 28) in a concentration of 1% under a gas pressure of 10⁻⁷ torr. After depositing an emissive layer, an electron transporting layer of compound 27 is formed with a thickness of 25nm.

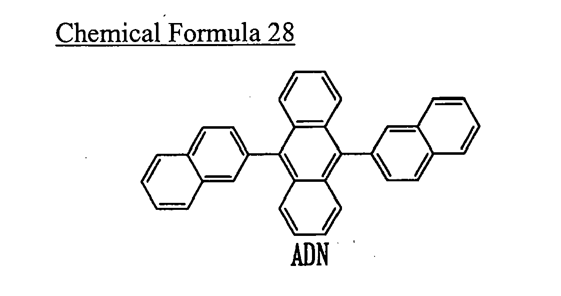

### Embodiment 2

A hole transporting layer having a thickness of 15nm is formed by using alpha-NPD of Chemical Formula 2 under a gas pressure of 10⁻⁷ torr on the surface of a substrate, on which an ITO film is deposited as an anode electrode. After the formation of the hole transporting layer, an emissive layer having a thickness of 30nm is established by depositing Blue dopant BD 118 of Idemitsu Kosan, Co., Ltd. to ADN in a concentration of 1% under a gas pressure of 10⁻⁷ torr. After forming an emissive layer, the electron transporting layer having a thickness of 25nm is formed by using a compound represented by Chemical Formula 27.

### Embodiment 3

A hole transporting layer having a thickness of 15nm is formed by using alpha-NPD of Chemical Formula 2 under a gas pressure of 10⁻⁷ torr on the surface of a substrate, on which an ITO film is deposited as an anode electrode. After the formation of the hole transporting layer, an emissive layer having a thickness of 30nm is established by depositing Blue dopant BD118 of Idemitsu Kosan, Co., Ltd. to ADN in a concentration of 1% under a gas pressure of 10⁻⁷ torr. After forming an emissive layer, the electron transporting layer having a thickness of 25nm is formed by using a compound represented by Chemical Formula 8.

### Comparative Example 1

A hole transporting layer having a thickness of 15nm is formed by using a compound represented by Chemical Formula 2 under a vacuum gas pressure of 10⁻⁷ torr on the surface of a substrate, on which an ITO film is deposited as an anode electrode. After the formation of the hole transporting layer, an emissive layer having a thickness of 30nm is established by depositing Blue dopant BD 118 of Idemitsu Kosan, Co., Ltd. to ADN in a concentration of 1% under a gas pressure of 10⁻⁷ torr. After forming an emissive layer, the electron transporting layer having a thickness of 25nm is formed by using Alq3.

### Comparative Example 2

A hole transporting layer having a thickness of 15nm is formed by using MTBDAB (Chemical Formula 24) under a gas pressure of 10⁻⁷ torr on the surface of a substrate, on which an ITO film is deposited as an anode electrode. After the formation of the hole transporting layer, an emissive layer having a thickness of 30nm is established by depositing Blue dopant BD118 of Idemitsu Kosan, Co., Ltd. to ADN in a concentration of 1% under a gas pressure of 10⁻⁷ torr. After forming an emissive layer, the electron transporting layer having a thickness of 25nm is formed by using a compound represented by Chemical Formula 27.

### Experimental example

Embodiments 1, 2 and 3 and the Comparative Examples described above were compared with one another in terms of luminance, luminous efficiency and color coordinate at 100mA/cm².

**Table 1**

| | Luminance | Luminous Efficiency (cd/a) | X | Y |
|---|---|---|---|---|
| Embodiment 1 | 8650 | 8.65 | 0.14 | 0.25 |
| Embodiment 2 | 7500 | 7.5 | 0.140 | 0.25 |
| Embodiment 3 | 7800 | 7.8 | 0.140 | 0.25 |
| Comparative Example 1 | 6320 | 6.328 | 0.140 | 0.25 |
| Comparative Example 2 | 6725 | 6.7 | 0.140 | 0.25 |

As shown in Table 1, the color coordinate properties are not changed while the luminance and the luminous efficiencies improve remarkably when the Embodiments are compared with the Comparative Examples. The first and second organic layers formed at both sides of the emissive layer serve to well maintain the charge balance between holes and electrons. In the foregoing discussions, those referred to as comparative examples do not necessarily represent prior art and the term "comparative example" does not constitute an admission of prior art.

In the embodiments described above, the first organic layer serves as a hole transporting layer and the second organic layer serves as an electron transporting layer. In other embodiments, other organic layers, such as hole injection layer, hole blocking layer, electron injection layer, electron blocking layer, and the like can be further included in the organic light emitting device.

Although certain embodiments have been shown and described, it would be appreciated by those skilled in the art that changes might be made in those embodiments without departing from the principles of the disclosure, the scope of which is defined in the claims and their equivalents.

## Claims

1. An organic light emitting device comprising:
a first electrode;
a second electrode;
an emissive layer interposed between the first and second electrodes;
a first organic layer interposed between the first electrode and the emissive layer, the first organic layer comprising a first compound, the first compound having a photoluminescence spectrum maximum wavelength of about 400nm to about 500nm; and
a second organic layer interposed between the second electrode and the emissive layer, the second organic layer comprising a second compound, the second compound having a photoluminescence spectrum maximum wavelength of about 400nm to about 500nm.

2. A device according to Claim 1, wherein the first organic layer is a hole transporting layer and wherein the second organic layer is an electron transporting layer.

3. A device according to Claim 1 or 2, wherein the first compound comprises at least one selected from the group consisting of compounds represented by Chemical Formulas 1 to 6, 10 to 22, and 25:

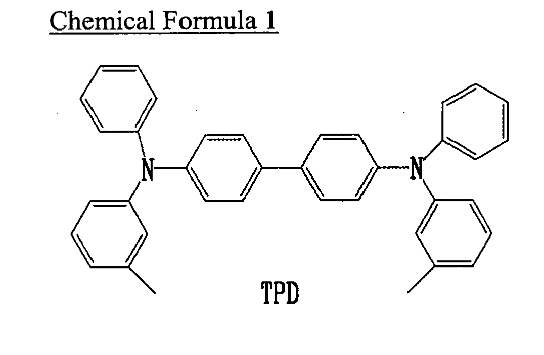

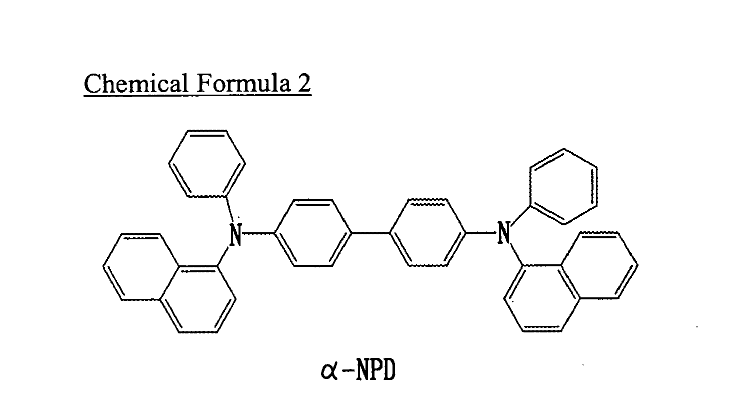

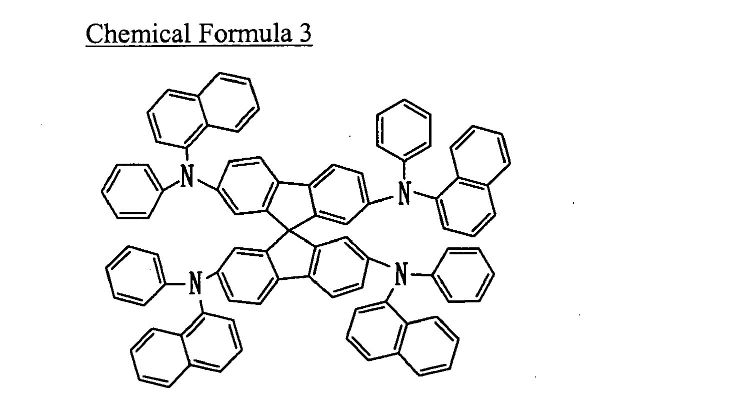

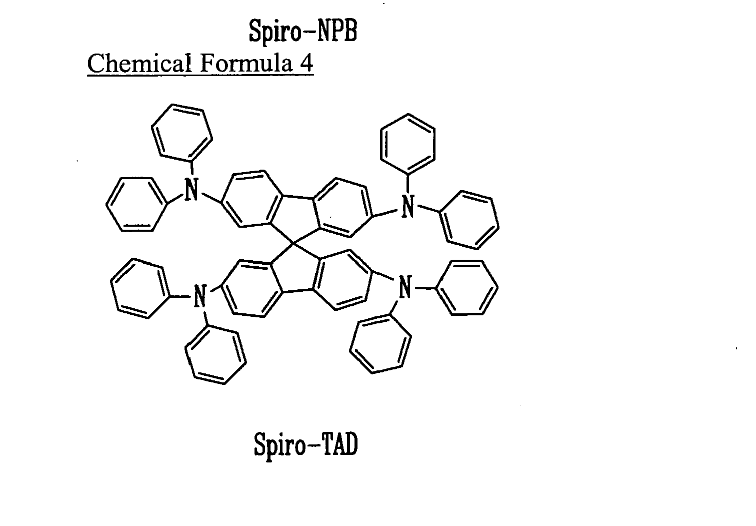

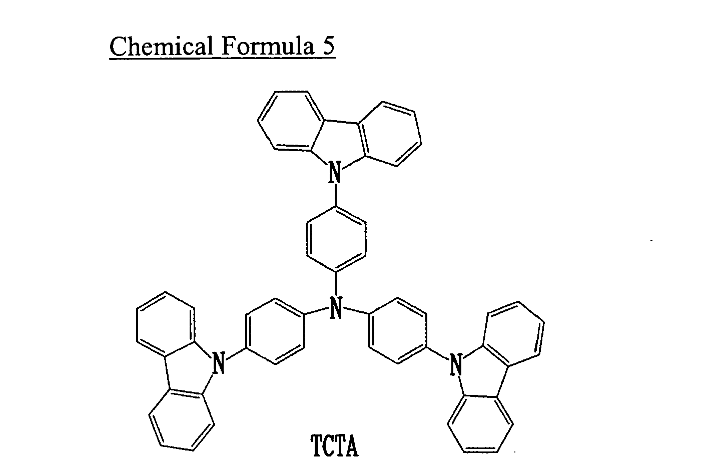

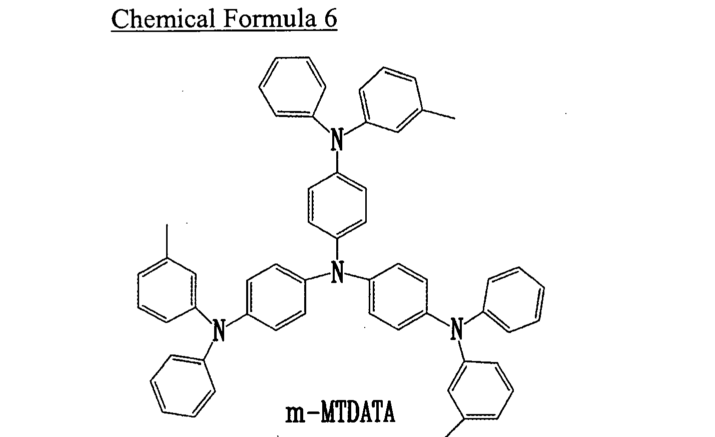

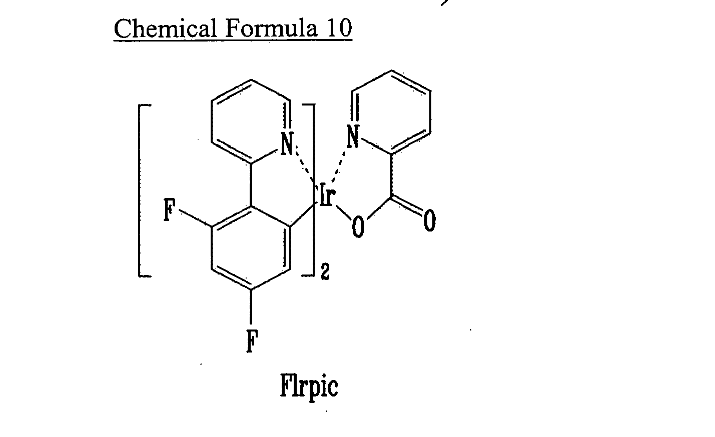

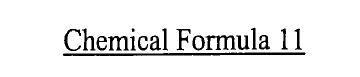

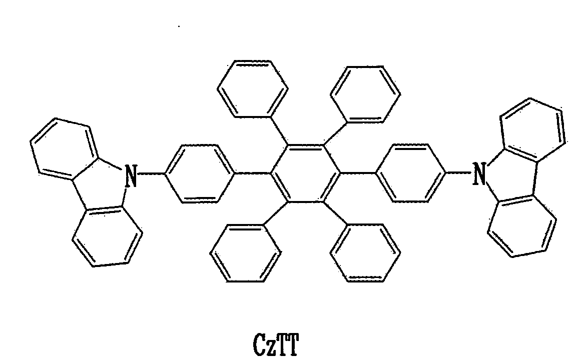

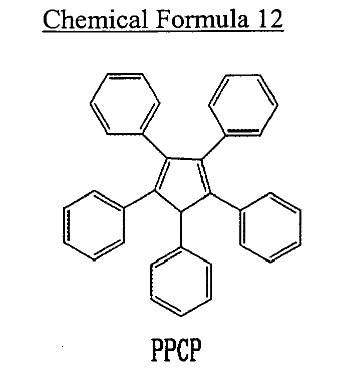

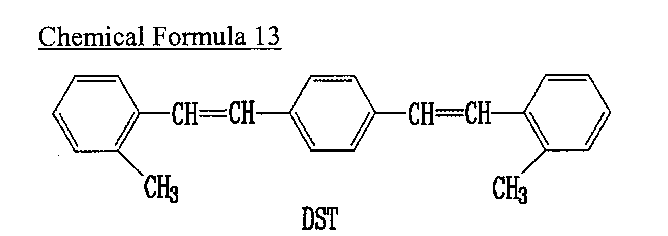

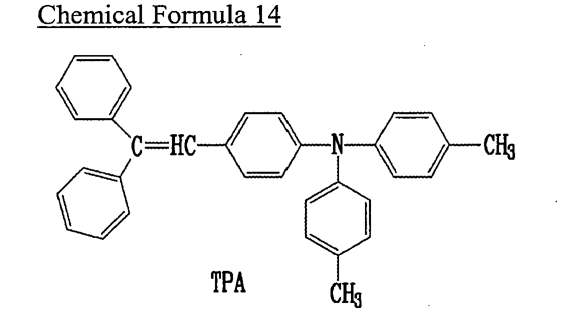

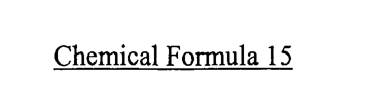

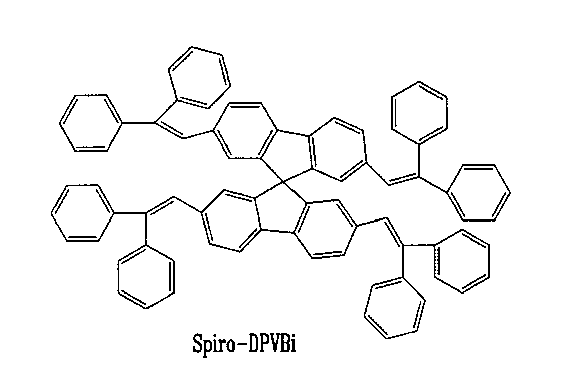

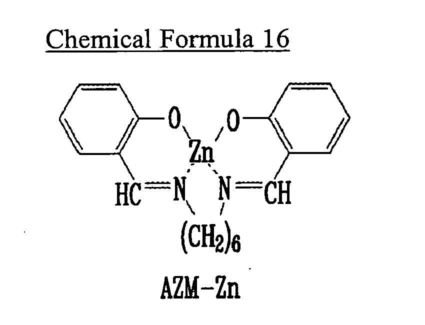

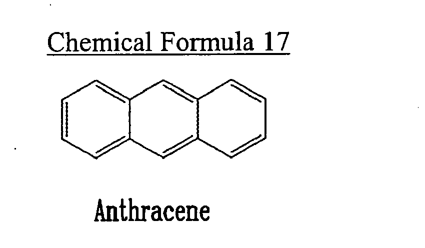

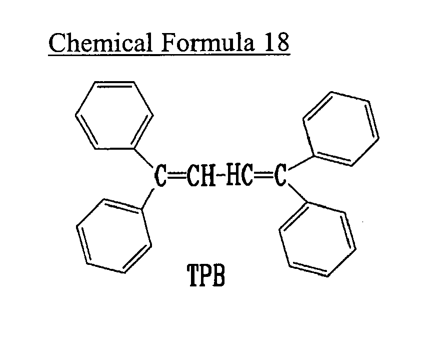

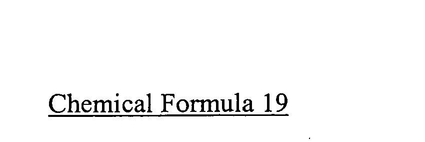

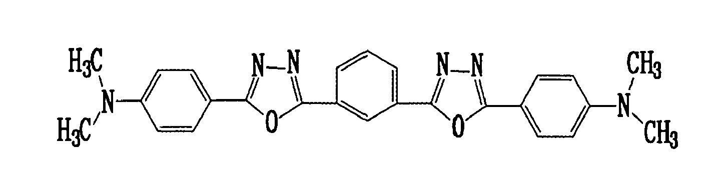

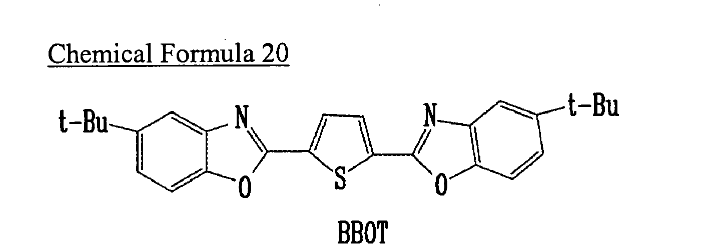

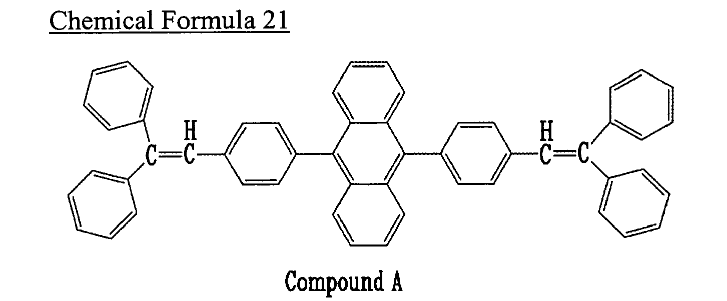

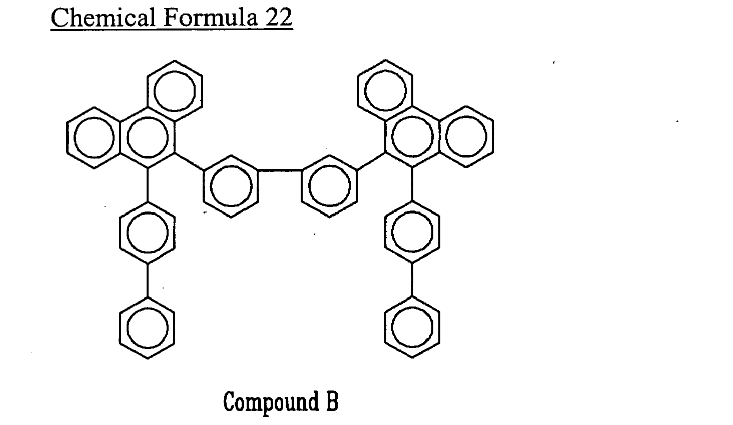

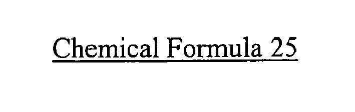

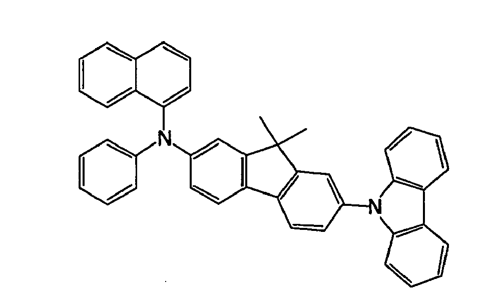

4. A device according to any one of Claims 1 to 3, wherein the first compound is in an amount of about 50 wt% to about 100 wt% with reference to the total weight of the first organic layer.

5. A device according to any one of Claims 1 to 4, wherein the second compound comprises at least one selected from the group consisting of compounds represented by Chemical Formulas 7 to 9, and 27.

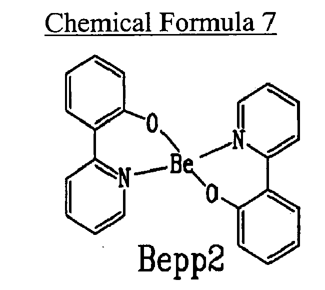

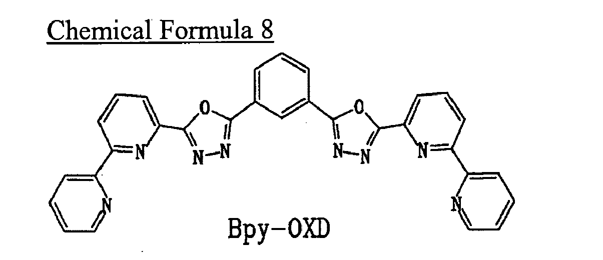

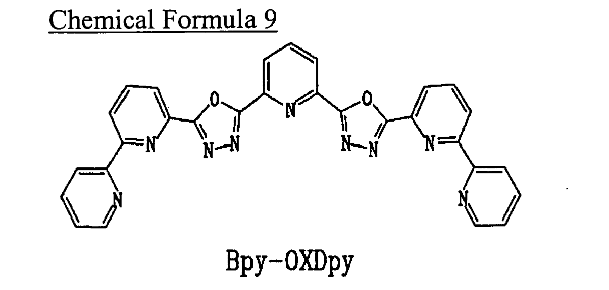

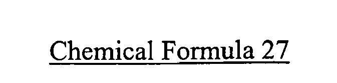

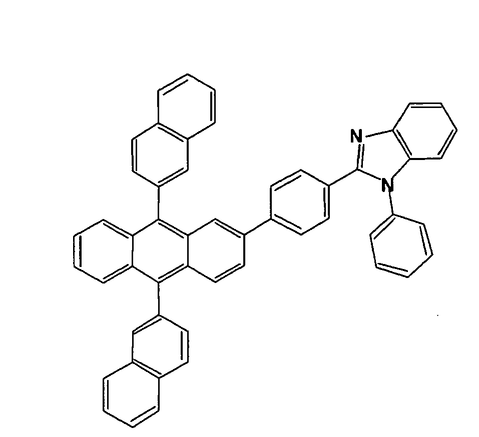

6. A device according to any one of Claims 1 to 5, wherein the second compound is in an amount of about 50 wt% to about 100 wt% with reference to the total weight of the second organic layer.

7. A device according to any one of Claims 1 to 6, wherein the first organic layer has a thickness of about 100Å to about 1,500Å.

8. A device according to any one of Claims 1 to 7, wherein the second organic layer has a thickness of about 150Å to about 600Å.

9. A device according to any one of Claims 1 to 7, wherein the first compound comprises one or more compounds selected from the group consisting of N,N'-di(1-naphthyl)-N-N'-diphenylbenzidine (NPD), bis(4-dimethylamino-2-methylphenyl)-phenylmethane, 1,1-bis(4-di-p-tolylaminophenyl)cyclohexane, and 1,1-bis(4-di-p-tolylaminophenyl)-4-phenylcyclohexane.

10. A device according to any one of Claims 1 to 9, wherein the second compound comprises one or more compounds selected from the group consisting of oligothiophene, perfluorinated oligo- p-phenylene, and 2,5-diarylsilole.

11. A device according to any one of Claims 1 to 10, further comprising a hole blocking layer interposed between the emissive layer and the second organic layer.

12. A device according to any one of Claims q to 11, further comprising an electron blocking layer interposed between the emissive layer and the first organic layer.

13. A device according to any one of Claims 1 to 12, wherein the emissive layer comprises a blue light- emitting organic compound.

14. A device according to Claim 13, wherein the first compound comprises a blue light-emitting organic compound.

15. A device according to Claim 13 or 14, wherein the second compound comprises a blue light-emitting organic compound.

16. An organic light emitting display device, comprising the device according to any one of Claims 1 to 15.

17. An electronic device comprising the organic light emitting display device of Claim 16.

18. A method of making an organic light emitting device, the method comprising:
providing a first electrode;
forming a first organic layer over the first electrode, the first organic layer comprising a first compound having a photoluminescence spectrum maximum wavelength of about 400nm to about 500nm;
forming an emissive layer over the first organic layer;
forming a second organic layer over the emissive layer, the second organic layer comprising a second compound having a photoluminescence spectrum maximum wavelength of about 400nm to about 500nm; and
forming a second electrode over the second organic layer.

19. A method according to Claim 18, wherein forming the first organic layer comprises using thermal evaporation or spin coating.

20. A method according to Claim 18 or 19, wherein forming the second organic layer comprises using vacuum-deposition.
